**Europäisches Patentamt**

**European Patent Office**

**Office européen des brevets**

(19)

(11) Veröffentlichungsnummer: **0 237 590**
**B1**

(12) **EUROPÄISCHE PATENTSCHRIFT**

(45) Veröffentlichungstag der Patentschrift:
**09.08.89**

(51) Int. Cl.⁴: **H03H 17/08,** H04N 9/64,
H04N 9/66

(21) Anmeldenummer: **86103522.8**

(22) Anmeldetag: **15.03.86**

(54) **Regelschaltung zur Regelung von zwei ca. 90o Phasenverschiebung aufweisenden Signalen.**

(43) Veröffentlichungstag der Anmeldung:
23.09.87 Patentblatt 87/39

(45) Bekanntmachung des Hinweises auf die Patenterteilung:
09.08.89 Patentblatt 89/32

(84) Benannte Vertragsstaaten:
**DE FR NL**

(56) Entgegenhaltungen:
**EP-A- 0 122 538**
**EP-A- 0 179 948**
**FR-A- 2 538 657**
**US-A- 4 489 392**

(73) Patentinhaber: **Deutsche ITT Industries GmbH,**
**Hans-Bunte-Strasse 19 Postfach 840,**
**D-7800 Freiburg(DE)**

(72) Erfinder: **Mehrgardt, Sönke, Dr., Häglestrasse 26,**
**D-7801 March(DE)**

**Beschreibung**

Die Erfindung betrifft eine Regelschaltung zur Regelung von zwei ca. 90°Phasenverschiebung aufweisenden Signalen auf exakt zueinander phasenverschobenen Signalverlauf und zur Regelung auf exakt gleiche Amplituden entsprechend dem Oberbegriff des Anspruchs 1. Eine derartige Regelschaltung ist in der Offenlegungsschrift DE-A-33 13 867 beschrieben. Fig. 1 mit zugehöriger Beschreibung auf Seite 8, Zeile 1 bis Seite 11, Zeile 6 dienen der Erläuterung dieser Regelschaltung mit zugehöriger Phasenregelstufe und Amplitudenregelstufe. Die Regelschaltung ist dabei Teilschaltung eines Überlagerungsempfängers, welcher ein hochfrequent empfangenes Signalgemisch - hier ein Farb-Bild-Austast-Synchron-Signalgemisch (= FBAS-Signalgemisch) - nach der "Dritten Methode" direkt mit Hilfe eines hochfrequenten Quadraturmischers in das Basisband transformiert, wobei das obere und das untere Seitenband übereinander zu liegen kommen. Mittels eines niederfrequenten Quadraturmischers wird das Signalgemisch in die übliche NF-Frequenzlage transformiert; dabei wird das unerwünschte Seitenband unterdrückt, vgl. "Proc. IRE", Dec. 1956, Seiten 1703-1705, "A Third Method of Generation and Detection of Single Side Band Signals".

Bei derartigen Schaltungen, insbesondere wenn sie zur Umsetzung des hochfrequent übertragenen Fernseh-Signalgemisches nach dem PAL- bzw. NTSC-Fernseh-Standard verwendet werden, ist eine genaue 90°-Phasenverschiebung und Amplitudengleichheit für die beiden Quadratursignalwege mit dem ersten bzw. dem zweiten Quadraturanalogsignal erforderlich, weil andernfalls unzulässige Störungen in Bild- und Tonwiedergabe die Folge wären.

Ein Nachteil der vorbeschriebenen Regelschaltung ist, daß die Phasenregelstufe in die empfindliche 90°-Phasendrehung des Hochfrequenzoszillators im hochfrequenten Quadraturmischer eingreift und damit selbst empfindlich und störanfällig ist. Ungünstig ist ferner, daß die Phasenabweichung mittels des Phasenvergleichs im Basisband, also bei niederen Frequenzen ermittelt wird, die Phasennachstellung selbst jedoch auf der Hochfrequenzseite stattfindet, was regelungstechnisch wegen des großen Frequenzunterschieds beim direkten Umsetzungsverfahren ungünstig ist. Ein weiterer Nachteil der vorbeschriebenen Regelschaltung ist, daß die Amplitudenregelstufe nur auf reine Amplitudenänderungen anspricht. Die Amplitudengleichheit der beiden Signalwege sollte sich hingegen auf die Amplitudengleichheit jeweils gleicher Frequenzkomponenten der beiden Quadraturanalogsignale beziehen.

Der in den Ansprüchen gekennzeichneten Erfindung liegt daher die Aufgabe zugrunde, eine Regelschaltung anzugeben, welche die exakte Einstellung der 90°-Phasenverschiebung der zwei ca. 90° Phasenverschiebung aufweisenden Signale ergibt, welche ferner deren Amplituden- gleichheit bezüglich der jeweiligen Frequenzkomponenten möglichst herstellt und darüberhinaus mindestens teilweise monolithisch integrierbar ist.

Die Erfindung wird nun anhand der Figuren der Zeichnung näher erläutert:

Fig. 1 zeigt in Form eines Blockschaltbildes schematisch die Regelschaltung,

Fig. 2a und b zeigen in Form eines Blockschaltbildes je ein Ausführungsbeispiel der Phasenregelstufe,

Fig. 3a und b zeigen in Form eines Blockschaltbildes je ein Ausführungsbeispiel der Amplitudenregelstufe,

Fig. 4 zeigt das Blockschaltbild eines Ausführungsbeispiels des Amplitudenvergleichers, und

Fig. 5 zeigt ein Zeigerdiagramm zur Erläuterung der Funktionsweise der Regelschaltung.

Der Grundgedanke der Erfindung besteht darin, das erste und das zweite Quadraturanalogsignal $s1$, $s2$ zu digitalisieren und mit Hilfe digitaler Schaltungen, welche Daten anstatt Analogwerte verarbeiten, die Phasen- und die Amplitudenregelung vorzunehmen. Die Phasenregelstufe pr hat dabei keine Rückführung auf die Hochfrequenzseite, sondern sie ändert je nach der gemessenen Phasendifferenz nur die Daten der beiden digitalisierten Quadraturanalogsignale, die zur Unterscheidung vom ersten und zweiten Quadraturanalogsignal $s1$, $s2$ als erstes und zweites Digitalsignal $d1$, $d2$ bezeichnet sind. Die Ausgangssignal der Phasenregelstufe pr sind das erste und das zweite phasenrichtige Digitalsignal $p1$, $p2$.

Die beiden Ausgangssignale der Regelschaltung r sind das erste und das zweite Quadratursignal $q1$, $q2$ und stellen somit zwei geregelte Digitalsignale dar. Dieses erste und zweite Quadratursignal $q1$, $q2$ sowie das erste und zweite phasenrichtige Digitalsignal $p1$, $p2$ sind der Amplitudenregelstufe ar als Eingangssignale zugeführt. In ihr werden die Amplitudenwerte möglichst gleicher Frequenz des ersten und des zweiten Quadratursignals $q1$, $q2$ miteinander verglichen und mit dem Vergleichswert die Amplitudenkorrektur des ersten bzw. zweiten phasenrichtigen Digitalsignals $p1$, $p2$ durchgeführt.

Enthalten das erste und das zweite Quadraturanalogsignal $s1$, $s2$ ein FBAS-Signalgemisch, findet der Amplitudenvergleich nur während der Dauer des Horizontalsynchronimpulses statt, weil nur während dieser Zeit der Bildträger mit konstanter Amplitude und konstanter Frequenz gesendet wird. Außerhalb der Horizontalimpulsdauer liegt meist ein sehr wenig konstantes Amplituden- und Frequenzgemisch des modulierten Bild-, Farb- und mindestens eines modulierten Tonträgers vor.

Handelt es sich bei dem ersten und dem zweiten Quadraturanalogsignal $s1$, $s2$ dagegen um reine Audiosignale, basiert der Amplitudenvergleich in der Amplitudenregel stufe ar auf einem Vergleich der Effektivwerte (Root-Mean-Square-Wert = RMS-Wert) des ersten bzw. des zweiten Quadratursignals $q1$, $q2$. Damit wird eine ausreichende Annäherung an den Amplitudenvergleich jeweils gleicher Frequenzkomponenten erreicht.

Ein besonderer Vorteil der Erfindung besteht darin, daß durch die Digitalisierung der beiden von dem ersten und zweiten Quadraturanalogsignal s1, s2 ausgehenden Signalwege und die erfindungsgemäße Ausbildung der Phasenregelstufe pr und der Amplitudenregelstufe ar nicht zur die Beeinflussung der Hochfrequenzseite vermieden wird, sondern daß die Digitalisierung auch die störende gegenseitige Beeinflussung des ersten und des zweiten Signalweges verhindert. Ferner erlaubt die Digitalisierung ohne Abgleichmaßnahmen eine beliebige Genauigkeit bzw. Gleichheit der beiden Signalwege. Diese hängt nur von der verwendeten Wortbreite der Daten ab. Dadurch kann die Genauigkeit der Phasen- und Amplitudenregelung so hoch gewählt werden, daß die Genauigkeitsforderung an den hochfrequenten Quadraturmischer soweit reduziert werden kann, daß er monolithisch integrierbar ist.

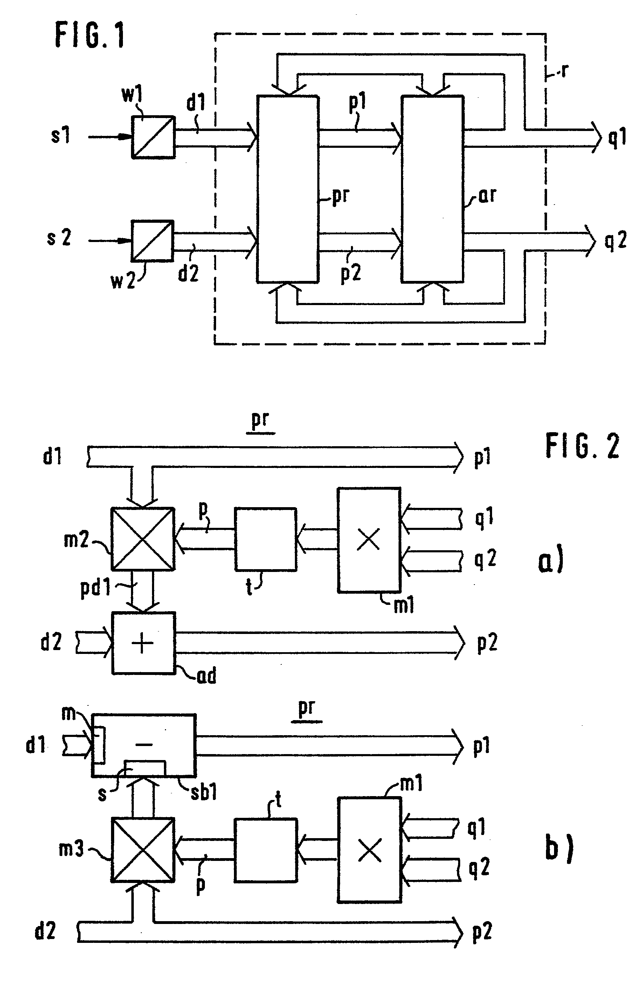

In Fig. 1 ist das dem hier nicht gezeigten hochfrequenten Quadraturmischer entstammende erste und zweite Quadraturanalogsignal s1, s2 dem ersten bzw. dem zweiten Analog-Digital-Wandler w1, w2 zugeführt und in das erste bzw. zweite Digitalsignal d1, d2 umgewandelt, das jeweils einem Eingang der Regelschaltung r zugeführt ist.

In der Regelschaltung r speisen das erste und das zweite Digitalsignal d1, d2 je einen Eingang der Phasenregelstufe pr, deren beide andere Eingänge jeweils mit einem der Ausgangssignale der Regelschaltung r gespeist sind, also mit dem ersten bzw. dem zweiten Quadratursignal q1, q2. Das erste und das zweite phasenrichtige Digitalsignal p1, p2 sind der Amplitudenregelstufe ar als Eingangssignale zugeführt. Ferner sind dieser das erste bzw. das zweite Quadratursignal q1, q2 an je einem zusätzlichen Eingang zugeführt. Die Ausgangssignale der Amplitudenregelstufe ar sind zugleich die Ausgangssignale der Regelschaltung r, also das erste bzw. das zweite Quadratursignal q1, q2, die dem hier nicht mehr gezeigten niederfrequenten Quadraturmischer zur weiteren Signalverarbeitung zugeführt sind.

Fig. 2a zeigt das Blockschaltbild eines ersten Ausführungsbeispiels der Phasenregelstufe pr. Den beiden Eingängen des ersten Multiplizierers m1 ist jeweils das erste bzw. das zweite Quadratursignal q1, q2 zugeführt und dessen Ausgang ist mit dem Eingang des Tiefpasses t verbunden, dessen Ausgangssignal, der Phasenregelwert p, dem ersten Eingang des zweiten Multiplizierers m2 zugeführt ist. Bei genau 90° Phasenverschiebung zwischen dem ersten und dem zweiten Quadratursignal q1, q2 nimmt der Phasenregelwert p den Wert null an. Dem zweiten Eingang des Multiplizierers m2 ist das erste Digitalsignal d1 zugeführt, das zugleich auch das erste Ausgangssignal der Phasenregelstufe pr ist und das somit in diesem Ausführungsbeispiel identisch mit dem ersten phasenrichtigen Digitalsignal p1 ist. Das zweite Ausgangssignal ist das zweite phasenrichtige Digitalsignal p2, welches das Summensignal aus dem zweiten Digitalsignal d2 und dem Ausgangssignal des zweiten Multiplizierers m2 ist und im Addierer ad gebildet wird.

Fig. 2b zeigt ein anderes Ausführungsbeispiel der Phasenregelstufe pr. Der aus der Multiplikation des ersten und zweiten Quadratursignals q1, q2 über den Tiefpaß t sich ergebende Phasenregelwert p ist dem ersten Eingang des dritten Multiplizierers m3 zugeführt, dessen zweiter Eingang mit dem zweiten Digitalsignal d2 gespeist ist, das hier zugleich auch das zweite phasenrichtige Digitalsignal p2 ist. Der Ausgang des dritten Multiplizierers m3 speist den Subtrahend-Eingang s des ersten Subtrahierers sb1, dessen Minuend-Eingang m das erste Digitalsignal d1 zugeführt ist. Das Ausgangssignal des ersten Subtrahierers sb1 ist das erste phasenrichtige Digitalsignal p1.

Je nach Ausführungsbeispiel bildet der Phasenregelwert p zusammen mit dem ersten bzw. zweiten Digitalsignal d1, d2 ein Produkt, das zum zweiten Digitalsignal d2 addiert bzw. vom ersten Digitalsignal d1 subtrahiert wird. Das daraus entstehende zweite bzw. erste phasenrichtige Digitalsignal p2, p1 hat nun zwar die richtige Phasenlage, die Amplitudenwerte stimmen aber noch nicht überein. Einmal ändert die eben beschriebene Phasenregelung das ursprüngliche Amplitudenverhältnis, zum anderen stammen die Amplitudenfehler auch aus der fehlerhaften hochfrequenten Quadraturmischung und aus Ungleichheiten der beiden analogen Signalübertragungswege. Die Amplituden gleichheit wird nun in der Amplitudenregelstufe ar, die der Phasenregelstufe pr nachgeschaltet ist, wiederhergestellt.

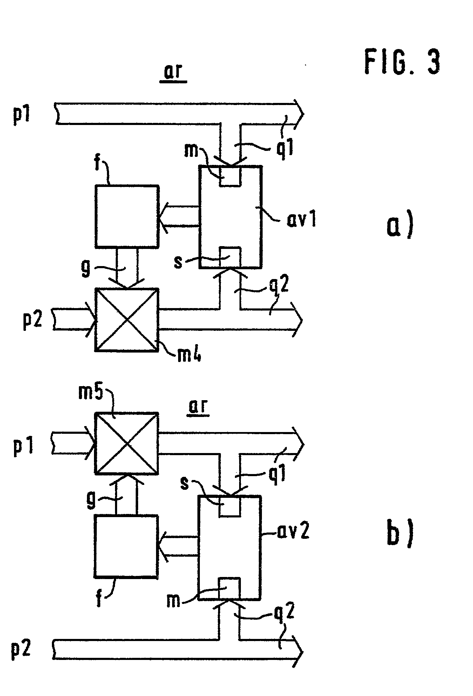

Fig. 3a zeigt das Blockschaltbild eines ersten Ausführungsbeispiels der Amplitudenregelstufe ar. Das erste phasenrichtige Digitalsignal p1 ist zugleich deren eines Ausgangssignal, nämlich das erste Quadratursignal q1, und speist den Minuend-Eingang m des ersten Amplitudenvergleichers av1. Dessen Subtrahend-Eingang s ist das zweite Quadratursignal q2 zugeführt, welches das Ausgangssignal des vierten Multiplizierers m4 ist. Der Ausgang des ersten Amplitudenvergleichers av1 ist mit dem Eingang des Mittelwertbildners f verbunden, dessen Ausgangssignal, der Amplitudenregelwert g, dem ersten Eingang des vierten Multiplizierers m4 zugeführt ist. Dieser dient somit der Produktbildung aus Amplitudenregelwert g und dem am zweiten Eingang zugeführten phasenrichtigen Digitalsignal p2. Das Produkt ist das zweite Quadratursignal q2.

Beim weiteren Ausführungsbeispiel der Amplitudenregelstufe ar nach Fig. 3b wird das erste Quadratursignal q1 mittels des fünften Multiplizierers m5 aus dem Amplitudenregelwert g und dem ersten phasenrichtigen Digitalsignal p1 erzeugt. Da die Amplitudenkorrektur somit am ersten phasenrichtigen Digitalsignal p1 stattfindet, sind im Vergleich zum ersten Amplitudenvergleicher av1 nach Fig. 3a in Fig. 3b der Minuend- und der Subtrahend-Eingang m, s des zweiten Amplitudenvergleichers av2 bezogen auf das erste bzw. zweite Quadratursignal q1, q2 ver tauscht. Am Minuend-Eingang m des zweiten Amplitudenvergleichers av2 liegt das zweite Quadratursignal q2, das zugleich das zweite phasenrichtige Digitalsignal p2 ist. Dem Subtrahend-Eingang s des zweiten Phasenvergleichers av2 ist das erste Quadratursignal q1 zugeführt, welches das Ausgangssignal des fünften Multiplizierers m5 ist. Der Ausgang des zweiten Amplitudenvergleichers av2 ist mit dem Eingang des Mittelwertbildners f verbunden, dessen Ausgangssignal, der Amplitudenregelwert g, den zweiten Eingang des fünften Multiplizierers m5 speist. Dessen zweitem Eingang ist das erste phasenrichtige Digitalsignal p1 zugeführt.

Die beiden Amplitudenvergleicher av1, av2 haben die Grundfunktion von Subtrahieren, worauf die gewählte Bezeichnung von deren Eingängen als Minuend- bzw. Subtrahend-Eingang m, s beruht. Der vierte und der fünfte Multiplizierer m4, m5 entsprechen den beim eingangs angegebenen Stand der Technik vorhandenen Signalverstärken.

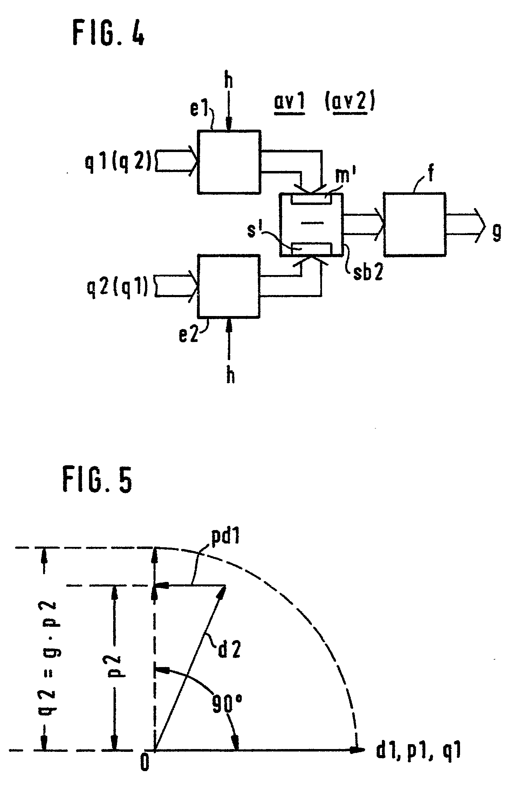

In Fig. 4 ist in Form eines Blockschaltbildes ein Ausführungsbeispiel des ersten bzw. zweiten Amplitudenvergleichers av1, av2 dargestellt. Sie bestehen jeweils aus dem zweiten Subtrahierer sb2, dem seinem Minuend-Eingang m' vorgeschalteten ersten Amplitudenbewerter e1 und dem seinem Subtrahend-Eingang s' vorgeschalteten zweiten Amplitudenbewerter e2. Die Zuordnung der entsprechenden Eingangssignale ist gleich der von Fig. 3a bzw. Fig. 3b. Während der Dauer des Tastimpulses h werden die jeweiligen Eingangsdaten von dem Amplitudenbewertern e1, e2 übernommen. Der Tastimpuls h wird von hier nicht näher beschriebenen Schaltungsteilen, im Falle eines FBAS-Signalgemisches vorzugsweise während der Dauer des Horizontalsynchronimpulses, erzeugt und ebenso dem zweiten Amplitudenbewerter e2 als Tastimpuls h zugeführt. Das Ausgangssignal des zweiten Subtrahierers sb2 speist den Eingang des Mittelwertbildners f, der ausgangsseitig den Amplitudenregelwert g liefert.

In dem beschriebenen Ausführungsbeispiel kann der erste und der zweite Amplitudenbewerter e1, e2 je ein Absolutbetrags-Schaltkreis sein, der während des Meßintervalls, insbesondere während der Horizontalsynchronimpulsdauer des FBAS-Signals, den Betrag des jeweiligen Amplitudenmaximums bestimmt, wobei dieses entweder über einen Einzelvergleich oder rechnerisch aus einer Anzahl von Einzelmessungen in Form einer Hüllkurvenbestimmung als mittleres Amplitudenmaximum bestimmt wird.

Andererseits kann der erste und der zweite Amplitudenbewerter e1, e2 ein Effektivwertbildner (=RMS-Schaltung) sein, insbesondere wenn es sich bei dem ersten und zweiten Quadratursignal q1, q2 um Signale aus einem Audio-Signalgemisch handelt. In diesem Fall kann die Tastung mittels des Tastimpulses h entfallen.

Ferner ermöglicht die Verwendung von Filterschaltungen im ersten und zweiten Amplitudenbewerter e1, e2 eine weitere Verbesserung der Amplitudenbewertung bezüglich bestimmter Frequenzbereiche.

In Fig. 5 wird anhand eines Zeigerdiagramms die Funktionsweise der Regelschaltung r bezüglich eines zueinander nicht um 90° phasenverschobenen ersten und zweiten Digitalsignals d1, d2 in Verbindung mit dem Ausführungsbeispiel für die Phasenregelstufe pr nach Fig. 2a und der Amplitudenregelstufe ar nach Fig. 3a gezeigt. Der das erste Digitalsignal d1, das erste phasenrichtige Digi talsignal p1 und das erste Quadratursignal q1 repräsentierende Zeiger liegt horizontal.

Der Winkelabstand des das zweite Digitalsignal d2 repräsentierenden Zeigers zum ersten Digitalsignal d1 ist voraussetzungsgemäß kleiner als 90° und sein Betrag ebenfalls kleiner als der des ersten Digitalsignals d1. Da die Phasendifferenz kleiner als 90° ist, ist der Phasenregelwert p negativ. Der im zweiten Multiplizierer m2 als Produkt aus dem ersten Datensignal d1 und dem Phasenregelwert p erzeugte Phasenkorrekturwert pd1 ist damit ebenfalls negativ, wenn die Richtung des Zeigers des ersten Digitalsignals d1 die positive ist.

Die vektorielle Addition vom zweiten Digitalsignal d2 und Phasenkorrekturwert pd1 führt zum vertikalen Zeiger, der dem zweiten phasenrichtigen Digitalsignal p2 entspricht. Die Lage dieses Zeigers hat jetzt zum ersten Digitalsignal eine Phasendifferenz von exakt 90°, indessen entspricht der Betrag des Zeigers noch nicht dem Betrag des Zeigers des ersten Digitalsignals d1. In der Amplitudenregelstufe ar wird der Amplitudenregelwert g mit dem zweiten phasenrichtigen Digitalsignal p2 multipliziert und dieses Produkt g × p2 stellt das zweite Quadratursignal q2 mit der richtigen Amplitude in der richtigen Phasenlage dar. Damit ist der Regelungsvorgang der Regelschaltung r beendet.

Zur Unterdrückung des hochfrequent übertragenen Restseitenbandes mit Resträger sind auf der NF-Seite im ersten bzw. im zweiten Signalweg identische Tiefpaßfilter erforderlich, wobei die Lage und Steilheit von derern Nyquistflanke zur Unterdrückung von Verzerrungen innerhalb des Basisbandes je nach Art der Restseitenbandübertragung entsprechend zu wählen ist. Diese Tiefpaßfilter werden vorteilhaft als erstes bzw. als zweites digitales Tiefpaßfilter mit zueinander identischem Frequenzgang ausgeführt und zwischen den ersten bzw. den zweiten Analog-Digital-Wandler w1, w2 und die zugehörigen Eingänge der Regelschaltung r eingefügt. Das ermöglicht einen identischen Amplituden- und Frequenzgang in beiden Signalwegen, wobei die Filter als monolithisch integrierbare Digitalfilter realisierbar sind. Diese unterliegen natürlich keinen Toleranzen oder Alterungsprozessen und müssen auch nicht abgeglihen werden. Vor dem ersten und dem zweiten Analog-Digital-Wandler w1, w2 ist jeweils eine einfache analoge Siebstufe, die auch aus mehreren einzelnen Siebgliedern bestehen kann, erforderlich, welche Signalfrequenzen oberhalb des Basisbandes unterdrückt. Die Toleranzanforderungen an diese Siebstufe sind mit analogen integrierbaren Siebmitteln wie Widerständen, Kondensatoren und Stromquellen erfüllbar. Damit stellt die Regelschaltung r in Verbindung mit der direkten Frequenzumsetzung aus dem hochfrequent übertragenen Signalgemisch in das Basisband nach der "dritten Metho de" eine für konsumorientierte Geräte geeignete Methode der Frequenzumsetzung dar.

**Patentansprüche**

1. Regelschaltung zur Regelung von zwei ca. 90° Phasenverschiebung aufweisenden Signalen (= erstes und zweites Quadraturanalogsignal) (s1, s2) auf exakt zueinander phasenverschobenen Signalverlauf und zur Regelung auf exakt gleiche Amplituden

- mit einer Phasenregelstufe ,die einen Phasenvergleicher und einen Tiefpaß enthält, und
- mit einer Amplitudenregelstufe, die einen ersten bzw. einen zweiten Amplitudenvergleicher einen Mittelwertbildner und einen Signalverstärker enthält,

gekennzeichnet durch folgende Merkmale:
- die Regelschaltung (r) ist eine digitale,
- das erste bzw. das zweite Quadraturanalogsignal (s1, s2) ist einem ersten bzw. einem zweiten Analog-Digital-Wandler (w1, w2) eingangsseitig zugeführt, der ein erstes bzw. ein zweites Digitalsignal (d1, d2) abgibt,
- diese sind jeweils einem Eingang der Regelschaltung (r) zugeführt, die ein erstes bzw. ein zweites Quadratursignal (q1, q2) abgibt,
- die Phasenregelstufe (pr), die ein erstes bzw. ein zweites lediglich phasenrichtiges Digitalsignal (p1, p2) abgibt, enthält als Phasenvergleicher einen ersten Mul tiplizierer (m1), dem eingangsseitig das erste und das zweite Quadratursignal (q1, q2) zugeführt sind und der ausgangsseitig mit dem Tiefpaß (t) verbunden ist, dessen Ausgangssignal als Phasenregelwert (p) den ersten Eingang eines zweiten bzw. dritten Multiplizierers (m2, m3) speist,
- entweder ist
-- der zweite Eingang des zweiten Multiplizierers (m2) mit dem ersten Digitalsignal (d1) gespeist, das zugleich das erste phasenrichtige Digitalsignal (p1) ist, und
-- das Ausgangssignal des zweiten Multiplizierers (m2) sowie das zweite Digitalsignal (d2) sind jeweils einem Eingang eines Addierers (ad) zugeführt, dessen Summensignal das zweite phasenrichtige Digitalsignal (p2) ist,
- oder
-- der zweite Eingang des dritten Multiplizierers (m3) ist mit dem zweiten Digitalsignal (d2) gespeist, das zugleich das zweite phasenrichtige Digitalsignal (p2) ist, und
-- das Ausgangssignal des dritten Multiplizierers (m3) ist dem Subtrahend-Eingang (s) sowie das erste Digitalsignal (d1) dem Minuend-Eingang (m) eines ersten Subtrahierers (sb1) zugeführt, dessen Ausgangssignal das erste phasenrichtige Digitalsignal (p1) ist,
- der in der Amplitudenregelstufe (ar), deren Ausgangssignale das erste und das zweite Quadratursignal (q1, q2) sind, enthaltene Signalverstärker ist ein vierter bzw. ein fünfter Multiplizierer (m4, m5), dessen erster Eingang mit einem Amplitudenregelwert (g) aus dem Mittelwertbildner (f) gespeist ist, der eingangsseitig mit dem Ausgang des ersten bzw. des zweiten Amplitudenvergleichers (av1, av2) verbunden ist,
- die Amplitudenregelstufe (ar) regelt auf weitgehend gleiche Amplituden der jeweiligen Frequenzkomponenten,
- entweder ist
-- der zweite Eingang des vierten Multiplizierers (m4) mit dem zweiten phasenrichtigen Digitalsignal (p2) gespeist, und
-- das erste phasenrichtige Digitalsignal (p1) ist zugleich das erste Quadratursignal (q1), das den Minuend-Eingang (m) des ersten Amplitudenvergleichers (av1) speist, und
-- das Ausgangssignal des vierten Multiplizierers (m3) ist das zweite Quadratursignal (q2), das den Subtrahend-Eingang (s) des ersten Amplitudenvergleichers (av1) speist,
- oder
-- der zweite Eingang des fünften Multiplizierers (m5) ist mit dem ersten phasenrichtigen Digitalsignal (p1) gespeist, und
-- das zweite phasenrichtige Digitalsignal (p2) ist zugleich das zweite Quadratursignal (q2), das den Minuend-Eingang (m) des zweiten Amplitudenvergleichers (av2) speist, und
-- das Ausgangssignal des fünften Multiplizierers (m5) ist das erste Quadratursignal (q1), das den Subtrahend-Eingang (s) des zweiten Amplitudenvergleichers (av2) speist.

2. Regelschaltung (r) nach Anspruch 1, gekennzeichnet durch folgende Merkmale:
- der erste bzw. zweite Amplitudenvergleicher (av1, av2) enthält minuendeingangsseitig einen ersten Amplitudenbewerter (e1), dessen Ausgang mit dem Minuend-Eingang (m) eines zweiten Subtrahierers (sb2) verbunden ist,
- der erste bzw. zweite Amplitudenvergleicher (av1, av2) enthält subtrahendeingangsseitig einen zweiten Amplitudenbewerter (e2), dessen Ausgang am Subtrahend-Eingang (s) des zweiten Subtrahierers (sb2) liegt, und
- der Mittelwertbildner (f) ist an den Ausgang des zweiten Subtrahierers (sb2) angeschlossen.

3. Regelschaltung (r) nach Anspruch 1 oder 2, dadurch gekennzeichnet, daß das erste und das zweite Quadratur analogsignal (s1, s2) einem in die Basislage transformierten FBAS-Signalgemisch (= Farb-Bild-Austast-Synchronsignalgemisch) oder einem in die Basisbandlage transformierten Audio-Signalgemisch entstammt.

4. Regelschaltung (r) nach Anspruch 3, gekennzeichnet durch folgende Merkmale:
- die Regelschaltung (r) sowie der erste und der zweite Analog-Digital-Wandler (w1, w2) sind wenigstens teilweise monolithisch integriert,
- dem ersten und dem zweiten Analog-Digital-Wandler (w1, w2) ist jeweils eine analoge Siebstufe vorgeschaltet, welche Signalfrequenzen oberhalb des Basisbandes unterdrückt, und
- zwischen den ersten bzw. den zweiten Analog-Digital-Wandler (w1, w2) und die zugehörigen Eingänge der Regelschaltung (r) ist jeweils ein digitales erstes bzw. ein digitales zweites Tiefpaßfilter mit zueinander identischem Frequenzgang eingefügt.

5. Regelschaltung (r) nach Anspruch 2 oder 3, gekennzeichnet durch folgende Merkmale:
- entweder ist der erste und der zweite Amplitudenbewerter (e1, e2) je ein Absolutbetrags-Schaltkreis, der während eines Meßintervalls, insbesondere während der Horizontal-Synchronimpulsdauer des FBAS-Signals, den Betrag des jeweiligen Amplitudenmaximums bestimmt, wobei dieses entweder über einen Einzelvergleich oder rechnerisch aus einer

Anzahl von Einzelmessungen in Form einer Hüllkurvenbestimmung als mittleres Amplitudenmaximum bestimmt ist,
- oder der erste bzw. der zweite Amplitudenbewerter (e1, e2) ist ein Effektivwertbildner (Root-Mean-Square-Schaltung = RMS-Schaltung), insbesondere wenn dessen jeweiliges Eingangsignal ein Audio-Signalgemisch ist.

**Revendications**

1. Circuit de régulation servant à réaliser le réglage de deux signaux possédant un déphasage égal à environ 90° (= premier et second signaux analogiques en quadrature) (s1, s2) de manière qu'ils possèdent des formes de variation déphasées de façon précise l'une par rapport à l'autre, et à réaliser le réglage sur des amplitudes exactement identiques
– comportant un étage de régulation de phase, qui contient un comparateur de phase et un filtre passe-bas, et
– un étage de régulation d'amplitude, qui contient un premier ou un second comparateur d'amplitude, un étage de formation de la valeur moyenne et un amplificateur de signaux, caractérisé par les caractéristiques suivantes:
– le circuit de régulation (r) est un circuit numérique,
– le premier ou le second signal analogique en quadrature (s1, s2) est envoyé à un premier ou à un second convertisseur analogique/numérique (w1, w2), qui délivre un premier ou un second signal numérique (d1, d2),
– ces signaux sont envoyés respectivement à une entrée du circuit de régulation (r), qui délivre un premier ou un second signal en quadrature (q1, q2),
– l'étage (pr) de régulation de phase, qui délivre un premier ou un second signal numérique (p1, p2) possédant uniquement une phase correcte, contient, en tant que comparateur de phase, un premier multiplicateur (m1) à l'entrée duquel sont envoyés les premier et second signaux en quadrature (q1, q2) et dont la sortie est reliée au filtre passe-bas (t), dont le signal de sortie est envoyé, en tant que valeur (p) de régulation de la phase, à la première entrée d'un second ou d'un troisième multiplicateur (m2, m3),
– et soit
—— la seconde entrée du second multiplicateur (m2) est alimentée par le premier signal numérique (d), qui est simultanément le premier signal numérique (p) correct du point de vue de la phase, et
—— le signal de sortie du second multiplicateur (m2) ainsi que le second signal numérique (d2) sont envoyés à des entrées respectives d'un additionneur (ad), dont le signal somme est le second signal numérique (p2) dont la phase est correcte,
– soit
—— la seconde entrée du troisième multiplicateur (m3) est alimentée par le second signal numérique (d2), qui constitue simultanément le second signal numérique (p2) correct du point de vue de la phase, et
—— le signal de sortie du troisième multiplicateur (m3) est envoyé à l'entrée (s) du nombre à soustraire d'un premier soustracteur (sb1) et le premier signal numérique (d) est envoyé à l'entrée (m) du diminuende de ce premier soustracteur, dont le signal de sortie est le premier signal numérique (p1) correct du point de vue de la phase,
– l'amplificateur de signaux, qui est prévu dans l'étage de régulation d'amplitude (ar), dont les signaux de sortie sont les premier et second signaux en quadrature (q1, q2), est un quatrième ou un cinquième multiplicateur (m4, m5), dont la première entrée est alimentée par la valeur de régulation d'amplitude (g) délivré par le dispositif (f) de formation de la valeur moyenne, dont l'entrée est reliée à la sortie du second comparateur d'amplitude (av1, av2),
– l'étage de régulation d'amplitude (ar) réalise le réglage sur des amplitudes presque identiques des composantes respectives de fréquence,
– et soit
—— la seconde entrée du quatrième multiplicateur (m4) est alimentée par le second signal numérique (p2) correct du point de vue de la phase, et
—— le premier signal numérique (p1), correct du point de vue de la phase, constitue simultanément le quatrième signal en quadrature (q1), qui alimente l'entrée (m) du diminuende du premier comparateur d'amplitude (av1), et
—— le signal de sortie du quatrième multiplicateur (m4) est le second signal en quadrature (q2), qui alimente l'entrée (s) du nombre à soustraire du premier comparateur d'amplitude (av1),
– soit
—— la seconde entrée du cinquième multiplicateur (m5) est alimentée par le premier signal numérique (p) correct du point de vue de la phase, et
—— le second signal numérique (p2), correct du point de vue de la phase, est simultanément le second signal en quadrature (q2), qui alimente l'entrée (m) du diminuende du second comparateur d'amplitude (av2), et
—— le signal de sortie du cinquième multiplicateur (m5) est le premier signal en quadrature (q1), qui alimente l'entrée (s) du nombre à soustraire du second comparateur d'amplitude (av2).

2. Circuit de régulation (r) selon la revendication 1, caractérisé par les caractéristiques suivantes:
– le premier ou le second comparateur d'amplitude (av1, av2) contient, au niveau de l'entrée du diminuende un premier dispositif (e1) d'évaluation de l'amplitude, dont la sortie est reliée à l'entrée (m) du diminuende d'un second soustracteur (sb2),
– le premier ou le second comparateur d'amplitude (av1, av2) contient, au niveau de l'entrée du nombre à soustraire, un second dispositif (e2) d'évaluation de l'amplitude, dont la sortie est raccordée à l'entrée (s) du nombre à soustraire du second soustracteur (sb2), et
– le dispositif (f) de formation de la valeur moyenne est raccordé à la sortie du second soustracteur (sb2).

3. Circuit de régulation (r) selon la revendication 1 ou 2, caractérisé en ce que les premier et second signaux analogiques en quadrature (s1, s2) proviennent d'un signal composite FBAS (= Farb-Bild-Austast-Synchronsignalgemisch, c'est-à-dire signal composite de chrominance), amené par transformation dans la position de base, ou un mélange de signaux audio, convertis dans la position de la bande de base.

4. Circuit de régulation (r) selon la revendication 3, caractérisé par les caractéristiques suivantes:

– le circuit de régulation (r) ainsi que les premier et second convertisseurs analogique/numérique (w1, w2), sont intégrés au moins partiellement sous forme analytique,

– en amont des premier et second convertisseurs analogique/numérique (w1, w2) sont branchés des étages analogiques respectifs de filtrage, qui suppriment des fréquences du signal au-dessus de la bande de base, et

– un premier filtre passe-bas numérique et un second filtre passe-bas numérique, qui possèdent des réponses en fréquence identiques, sont insérés respectivement entre le premier ou le second convertisseur analogique/numérique (w1, w2) et les entrées associées du circuit de régulation (r).

5. Circuit de régulation (r) selon la revendication 2 ou 3, caractérisé par les caractéristiques suivantes:

– soit les premier et second dispositifs (e1, e2) d'évaluation d'amplitudes sont constitués par des circuits respectifs délivrant des valeurs absolues, qui déterminent la valeur du maximum d'amplitude respectif, pendant un intervalle de mesure, notamment pendant la durée de l'impulsion de synchronisation horizontale du signal FBAS, ce maximum étant déterminé en tant que maximum moyen d'amplitude, soit par une comparaison individuelle, soit par calcul, à partir de plusieurs mesures individuelles sous la forme d'une détermination d'une courbe enveloppe,

– soit le premier ou le second dispositif (e1, e2) d'évaluation d'amplitudes est un dispositif de formation de la valeur efficace (circuit Root-Mean-Square = circuit RMS), notamment lorsque le signal d'entrée respectif de ce dispositif est un signal audio composite.

## Claims

1. Circuit for controlling two signals approximately 90° apart in phase (= first and second quadrature analog signals) (s1, s2) so as to obtain two signal waveforms having a phase difference of exactly 90° and exactly equal amplitudes, comprising

– a phase control stage containing a phase comparator and a low-pass filter, and

– an amplitude control stage containing a first or second amplitude comparator, an averaging device, and a signal amplifier,

characterized by the following features:

– the control circuit (r) is a digital circuit;

– the first and second quadrature analog signals (s1, s2) are fed, respectively, to a first analog-to-digital converter (w1), which provides a first digital signal (d1), and to a second analog-to-digital converter (w2), which provides a second digital signal (d2);

– the first and second digital signals (d1, d2) are each applied to one input of the control circuit (r), which provides a first quadrature signal (q1) and a second quadrature signal (q2);

– the phase comparator in the phase control stage (pr), which provides a first phase-corrected digital

signal (p1) and a second phase-corrected digital signal (p2), is a first multiplier (m1) which is fed with the first and second quadrature signals (q1, q2) and has its output connected to the low-pass filter (t), whose output is fed as a phase control value (p) to the first input of a second or third multiplier (m2, m3);

– either

— the second input of the second multiplier (m2) is fed with the first digital signal (d1), which is also the first phase-corrected digital signal (p1), and

— the output signal from the second multiplier (m2) and the second digital signal (d2) are each applied to one input of an adder (ad), whose sum signal is the second phase-corrected digital signal (p2),

– or

— the second input of the third multiplier (m3) is fed with the second digital signal (d2), which is also the second phase-corrected digital signal (p2), and

— the output signal from the third multiplier (m3) and the first digital signal (d1) are applied, respectively, to the subtrahend input (s) and the minuend input (m) of a first subtracter (sb1), whose output is the first phase-corrected digital signal (p1);

– the signal amplifier contained in the amplitude control stage (ar), whose output signals are the first and second quadrature signals (q1, q2), is a fourth or fifth multiplier (m4, m5) whose first input is fed with an amplitude control value (g) from the averaging device (f), which has its input connected to the output of the first or second amplitude comparator (av1, av2);

– the amplitude control stage (ar) adjusts the amplitudes of the respective frequency components to substantially identical values;

– either

— the second input of the fourth multiplier (m4) is fed with the second phase-corrected digital signal (p2), and

— the first phase-corrected digital signal (p1) is also the first quadrature signal (p1), which is applied to the minuend input (m) of the first amplitude comparator (av1), and

— the output of the fourth multiplier (m4) is the second quadrature signal (q2), which is applied to the subtrahend input (s) of the first amplitude comparator (av1),

– or

— the second input of the fifth multiplier (m5) is fed with the first phase-corrected digital signal (p1), and

— the second phase-corrected digital signal (p2) is also the second quadrature signal (q2), which is applied to the minuend input (m) of the second amplitude comparator (av2), and

— the output of the fifth multiplier (m5) is the first quadrature signal (q1), which is applied to the subtrahend input (s) of the second amplitude comparator (av2).

2. A control circuit (r) as claimed in claim 1, characterized by the following features:

– the first or second amplitude comparator (av1, av2) contains on the minuend-input side a first amplitude evaluator (e1) having its output connected to the minuend input (m) of a second subtracter (sb2);

– the first or second amplitude comparator (av1, av2) contains on the subtrahend-input side a second amplitude evaluator (e2) having its output connected to the subtrahend input (s) of the second subtracter (sb2), and
– the averaging device (f) is connected to the output of the second subtracter (sb2).

3. A control circuit (r) as claimed in claim 1 or 2, characterized in that the first and second quadrature analog signals (s1, s2) originate from a composite color or audio signal converted to the baseband.

4. A control circuit (r) as claimed in claim 3, characterized by the following features:
– the control circuit (r) as well as the first and second analog-to-digital converters (w1, w2) are implemented, at least in part, using integrated circuit techniques;
– the first and second analog-to-digital converters (w1, w2) are each preceded by an analog filter stage for suppressing signal frequencies above the baseband, and
– a first digital low-pass filter is interposed between the first analog-to-digital converter (w1) and the associated input of the control circuit (r), and a second digital low-pass filter having the same frequency response as the first digital low-pass filter is interposed between the second analog-to-digital converter (w2) and the associated input of the control circuit (r).

5. A control circuit (r) as claimed in claim 2 or 3, characterized by the following features:
– the first and second amplitude evaluators (e1, e2) are absolute-value devices which determine the absolute value of the respective amplitude maximum during a measurement interval, particularly during the horizontal synchronizing pulse of the composite color signal, the amplitude maximum being determined either by individual comparisons or mathematically as an average maximum by forming an envelope from a number of individual measurements, or
– the first and second amplitude evaluators (e1, e2) are root-mean-square devices, particularly if their input signals are composite audio signals.

FIG.1

FIG. 2

a)

b)

FIG. 3

ar

p1

f

m

q1

av1

a)

g

s

p2

q2

m4

m5

ar

p1

s

q1

g

av2

b)

f

m

p2

q2

FIG. 4

e1  <u>av1</u>  <u>(av2)</u>

q1(q2)

h

m'

f

g

s'

sb2

q2(q1)

e2

h

FIG. 5

pd1

q2 = g · p2

p2

d2

90°

d1, p1, q1

0